# EUROPÄISCHE PATENTSCHRIFT

(11) **EP 3 741 027 B1**
(45) Veröffentlichungstag und Bekanntmachung des Hinweises auf die Patenterteilung: **19.06.2024**
(21) Anmeldenummer: 18710353.6
(22) Anmeldetag: 26.02.2018
(51) Int. Cl.: H02J 13/00, H04Q 9/00

(54) **SCHALTANLAGE FÜR HOCH- BZW. MITTELSPANNUNGSTECHNIK**
SWITCHING STATION OF HIGH-VOLTAGE OR MEDIUM-VOLTAGE EQUIPMENT
ÉQUIPEMENT À HAUTE OU MOYENNE TENSION

(43) Veröffentlichungstag der Anmeldung: 25.11.2020
(73) Patentinhaber: Siemens Energy Global GmbH & Co. KG, 81739 München (DE)
(72) Erfinder: HOLZAPFEL, Johann, 2134 Staatz-Kautendorf (AT); RENTSCHLER, Alexander, 64625 Bensheim (DE); SCHIRRMACHER, Florian, 90427 Nürnberg (DE); WALLNER, Christian, 91058 Erlangen (DE); WEIGT, Uwe, 91056 Erlangen (DE)
(86) Internationale Anmeldenummer: PCT/EP2018/054659
(87) Internationale Veröffentlichungsnummer: WO 2019/161929

(56) Entgegenhaltungen:
- EP-A1- 2 903 297
- EP-A2- 0 231 909
- US-A1- 2008 218 148
- US-A1- 2017 048 598
- US-A1- 2017 134 216

## Beschreibung

Die vorliegende Erfindung betrifft eine Schalanlage für Hoch- bzw. Mittelspannungs-Technik, und betrifft ferner ein Verfahren für Hoch- bzw. Mittelspannungs-Technik, wobei insbesondere ein Produktlebenszyklus und/oder ein Herstellungsprozess oder/und ein Betrieb einer Ausstattung für Mittel- bzw. Hochspannungs-Technik überwacht werden.

Eine Schaltanlage in der Hoch- bzw. Mittelspannungs-Technik ist eine Anlage, in der elektrische Energie verteilt oder umgespannt werden kann. Schaltanlagen, insbesondere ihre Sammelschienen, können Knoten von Hoch-, Mittel- bzw. Niederspannungsnetzen bilden. Die beiden Schaltanlagen in dem Knoten ankommenden und abgehenden Leitungen können als Abzweige bezeichnet werden, welche für Einspeisungen, Abgänge und Kupplungen zu anderen Netzknoten ausgebildet sein können. Über Schaltgeräte können die Abzweige einer Schaltanlage mit anderen Netzknoten verbunden werden. Die Schaltgeräte können z.B. Leistungs-Transistoren, Leistungsschalter, etc. umfassen. Die Schaltanlage selbst kann sowohl in einem geschlossenen Gebäude aufgestellt als auch als in Freiluftaufstellung ausgeführt sein, z.B. als ein oder mehrere Schaltzellen ausgebildet sein. Für einen sicheren Betrieb müssen die verschiedenen Komponenten der Schaltanlage überwacht werden.

Insbesondere können über den Produktlebenszyklus eines Gerätes der Hoch- bzw. Mittelspannungs-Technik Informationen anfallen, die einerseits bekannt und zugänglich sind und andererseits nicht zugänglich sind und somit unbekannt sind. Bekannte Informationen sind z.B. geforderte Qualitätsprüfungen, welche protokolliert und abgespeichert werden. Unter unbekannte Informationen fallen z.B. Umgebungsbeanspruchungen, z.B. Beschleunigungen, Temperatur, Drehmomente, Druckbeanspruchungen oder auch die Verweildauer bei gewissen Umgebungsbedingungen. Die Information fallen zu unterschiedlichen Phasen des Lebenszyklus des Gerätes an. Herkömmlicherweise ist es nicht möglich, den Zustand eines Gerätes der Hoch- bzw. Mittelspannungs-Technik seinem Lebenszyklus zuzuordnen.

Herkömmlicherweise erfolgt eine Qualitätssicherung von Geräten der Hoch- bzw. Mittelspannungs-Technik zu vorher festgelegten Prüfzeitpunkten. Die Ermittlung der produktrelevanten Informationen bei der Herstellung erfolgt in vorgesehenen Prüfbereichen, z.B. in Prüfzellen/Prüflaboratorien. Die Daten werden darin von Prüffeldeinrichtungen ermittelt, erfasst und dem Prüfobjekt zugeschrieben. Vom Transport zur Baustelle können Transportbeanspruchungen mittels Schockindikatoren an Transportbaugruppen überwacht werden. Bei der Inbetriebnahme werden relevante Informationen mittels Prüfeinrichtungen erfasst und die vorgesehene Sensortechnik für den Betrieb mit dem lokalen System verbunden. Es erfolgt somit herkömmlicherweise keine kontinuierliche Datenerfassung, die für die Qualitäts- und Funktionsüberwachung genutzt werden könnte.

Technologie bedingt werden in dem Bereich von Hoch- und Mittelspannungs-Anlagen die Prozessdaten der Anlagen mit Hilfe von Wandler-Sensoren erfasst. Diese Daten (z.B. Strom, Spannung, Temperatur, Druck, Beschleunigung (Vibration), Feuchtigkeit etc.) werden drahtgebunden an ein übergeordnetes Auswertesystem übergeben. Die Versorgung der Wandler und Sensoren erfolgt auch drahtgebunden. Das Auswertesystem muss für jeden spezifischen Anwendungsfall separat parametrisiert werden. Die erfassten Daten können nur über weitere Sekundärsysteme genutzt werden.

Herkömmlicherweise werden Messdaten wie Strom, Spannung, Temperatur, Druck, Beschleunigung (Vibration), Feuchtigkeit, etc.) mit einem Sensor/Wandler gemessen. Je nach Messwert wird dieser anschließend drahtgebunden per Kabel an ein übergeordnetes Steuer-Schutzgerät übermittelt. Dazu müssen Kupfer- und Lichtwellenkabel durch die Anlage projektiert, verlegt und geprüft werden.

Somit ist die Überwachung von Ausstattung für die Mittel- bzw. Hochspannungs-Technik gemäß dem Stand der Technik aufwendig und erfordert eine komplexe Verkabelung. Dies gilt sowohl für einen Herstellungsprozess, einen Montageprozess oder auch während eines normalen Betriebes einer vollinstallierten Schaltanlage.

Aus der US 2017/0048598 A1 ist eine Anordnung zur Kabellosen Überwachung eines Transformators bekannt.

Ein Fernüberwachungssystem für einen Haushalt ist in der EP 2 903 297 A1 beschrieben.

Die EP 0 231 909 A2 offenbart ein Sensorsystem zur Verwendung bei einer Übertragungsleitung.

In der US 2008/218148 A1 ist ferner ein System zur Leistungsregelung und -überwachung offenbart.

Somit ist es eine Aufgabe der vorliegenden Erfindung, eine Vorrichtung bzw. ein Verfahren für Hoch- bzw. Mittelspannungs-Technik bereitzustellen, wobei zumindest einige der im Stand der Technik beobachteten Nachteile oder Probleme reduziert oder gar beseitigt sind.

Gemäß der vorliegenden Erfindung ist bereitgestellt eine Vorrichtung für Hoch- bzw. Mittelspannungstechnik, die eine Schaltanlage ist, aufweisend: zumindest einen Anschluss, der zur Verbindung mit einem Hoch- bzw. Mittelspannungsleiter, insbesondere Kabel und/oder gasisolierter Leiter und/oder Freileitungsleiter, ausgebildet ist; ein Sensorsystem, das ausgebildet ist, mehrere verschiedene die Vorrichtung betreffende und/oder das Kabel und/oder die Umgebung betreffende physikalische und/oder chemische Messwerte zu bestimmen; ein, insbesondere drahtlos arbeitendes, Kommunikationssystem, das ausgebildet ist, die Messwerte von dem Sensorsystem zu empfangen und an eine Entität in einem Netzwerk zu übertragen.

Die Vorrichtung ist erfindungsgemäß eine Schaltanlage, welche zum Verteilen oder Umspannen von Energie in einem Mittelspannungsnetz bzw. Hochspannungsnetz ausgebildet ist. Der zumindest eine Anschluss, der zur Verbindung mit einem Hoch- bzw. Mittelspannungskabel ausgebildet ist, kann eine Abzweigung implementieren, welche für Einspeisung und/oder Abgang von elektrischer Energie oder Kupplung zu anderen Netzknoten ausgebildet ist.

Das Sensorsystem kann ein oder mehrere Sensoren umfassen, welche an verschiedenen Orten der Vorrichtung angeordnet sind, insbesondere an verschiedenen Komponenten der Vorrichtung angeordnet sind, um die physikalischen und/oder chemischen Messwerte zu bestimmen. Die Vorrichtung kann mehrere (elektrische und/oder elektronische) Komponenten umfassen, bezüglich derer die Messwerte mittels des Sensorsystems bestimmt werden können. Das Sensorsystem kann auch Messwerte erfassen, welche sich auf eine in dem Kabel geführte elektrische Energie (z.B. Strom und Spannung) beziehen. Die Umgebung betreffenden Messwerte können Bedingungen um die Vorrichtung herum betreffen, z.B. Wetterbedingungen, Temperatur, Druck, Feuchte, etc. Das Sensorsystem kann somit eine umfassende Überwachung der Vorrichtung ermöglichen.

Das Kommunikationssystem kann ein oder mehrere Module (welche z.B. auch in den Sensoren integriert sein können) umfassen und kann mit allen Sensoren des Sensorsystems kommunikativ entweder unidirektional oder bidirektional verbunden sein. Die Messwerte der Sensoren des Sensorsystems können insbesondere durch Funkübertragung, d.h. drahtlos an das Kommunikationssystem übertragen werden und/oder drahtlos mittels des Kommunikationssystems an die Entität übertragen werden. Das Kommunikationssystem kann drahtgebunden oder drahtlos mit einem Kommunikationsnetzwerk verbunden sein, in welchem die Entität (z.B. ein Server mit einer Datenbank) befindlich ist. Das Kommunikationssystem kann somit teilweise drahtlos und teilweise drahtgebunden kommunizieren.

Das Sensorsystem kann ausgebildet sein, autark zu arbeiten, insbesondere kein besonders vorgesehenes Energieversorgungssystem zu erfordern. Damit kann eine einfach aufgebaute Vorrichtung für Hoch- bzw. Mittelspannungs-Technik bereitgestellt werden, welche eine Überwachung in verschiedenen Lebensphasen, z.B. Herstellung, Transport, Installation und/oder Betrieb ermöglicht.

Gemäß der vorliegenden Erfindung ist das Kommunikationssystem ausgebildet, bidirektionale Kommunikation zu erlauben, um Sensorkonfigurationsdaten zu erhalten und an das Sensorsystem zu übermitteln, welche das Sensorsystem insbesondere hinsichtlich Schutzfunktion und/oder Messfunktion und/oder Empfindlichkeit und/oder Abtastrate konfigurieren. Das Kommunikationssystem kann ausgebildet sein, Steuerdaten zu erhalten und an Komponenten der Vorrichtung zu übertragen, um einen Betrieb der Vorrichtung zu steuern. Das Kommunikationssystem kann ausgebildet sein, Schutzsteuerdaten an Komponenten der Vorrichtung zu übertragen, um Schutzfunktionen der Vorrichtung zu steuern.

Die Sensorkonfigurationsdaten können erlauben, die verschiedenen Sensoren des Sensorsystems zu konfigurieren, insbesondere hinsichtlich der vorzunehmenden Messungen, z.B. Messzeitpunkte, Abtastintervalle, Messverstärkungen etc. Das Kommunikationssystem kann z.B. Steuerdaten von einer Entität (z.B. Server) aus dem Netzwerk erhalten, welche z.B. von einem Betreiber der Vorrichtung bereitgestellt oder erzeugt wurden. Die Steuerdaten umfassen Steuersignale an Komponenten der Vorrichtung, um bestimmte Verbindungen zu dem mindestens einen Hoch- bzw. Mittelspannungsleiter zu schließen bzw. zu unterbrechen (z.B. mittels Leistungsschaltern und/oder Leistungstransistoren) anzusteuern. Die Schutzfunktionen der Komponenten können ausgebildet sein, die Vorrichtung vor Beschädigung zu schützen oder auch den Anschluss vor Beschädigung oder Beeinträchtigung zu schützen.

Gemäß einer Ausführungsform der vorliegenden Erfindung weist die Vorrichtung ferner ein Vorverarbeitungssystem auf, um die Messwerte zur Übertragung vorzubereiten, insbesondere zu digitalisieren und/oder mit Identifikationsdaten und/oder Zeitstempel zu versehen und/oder in mindestens ein Übertragungsdatenpaket zu konvertieren.

Die Sensoren des Sensorsystems können verschiedenartig ausgebildet sein und die Messwerte in jeweils spezifischen Formaten bereitstellen. Das Vorverarbeitungssystem kann diese verschiedenen Formate oder Repräsentationsweisen in ein einheitliches Format umwandeln bzw. konvertieren und insbesondere in ein einheitliches Übertragungsdatenformat überführen, um, insbesondere drahtlos, ein einheitliches Übertragungsdatenpaket oder mehrere Übertragungsdatenpakete für jeden Sensor des Sensorsystems an das Kommunikationssystem zu übertragen bzw. mittels des Kommunikationssystems an die Entität zu übertragen. Insbesondere kann das Kommunikationssystem für jeden Sensor des Sensorsystems ein Drahtlos-Übertragungsmodul umfassen, um die jeweiligen Messwerte von dem jeweiligen Sensor des Sensorsystems an die Entität zu übertragen. In dem Übertragungsdatenpaket kann z.B. die Art des Sensors, die Bedeutung des Messwertes, der Messzeitpunkt, die Abtastrate, die Empfindlichkeit usw. spezifiziert sein.

Gemäß einer Ausführungsform der vorliegenden Erfindung betreffen die Messwerte Standortdaten und/oder Beschleunigung und/oder Temperatur und/oder Drehmoment und/oder Druckbeanspruchung und/oder Verweildauer der Vorrichtung.

Alternative oder zusätzlich betreffen die Messwerte gemäß einer Ausführungsform der vorliegenden Erfindung Strom und/oder Spannung und/oder Temperatur und/oder Druck und/oder Beschleunigung und/oder Vibration und/oder Feuchte des elektrischen Leiters (z.B. über ein angeschlossenes Kabel, eine angeschlossene Freileitung oder einen gasisolierten Anschluss), das mit der Vorrichtung verbunden ist.

Somit kann eine umfassende Überwachung der Vorrichtung ermöglicht werden. Damit kann eine Qualitätssicherung oder ein sicherer Betrieb der Vorrichtung sichergestellt werden.

Gemäß einer Ausführungsform der vorliegenden Erfindung ist das Kommunikationssystem ausgebildet, sich autonom bei der Entität, insbesondere einer Datenbank (oder einem Server), und/oder im Netzwerk bekannt zu machen und/oder anzumelden. Das Kommunikationssystem kann ein zentrales Kommunikationssystem sein, welches von allen Sensoren des Sensorsystems die entsprechenden Messwerte erhält. In anderen Ausführungsformen bilden separate Kommunikationsmodule aller Sensoren des Sensorsystems gemeinsam das Kommunikationssystem. In diesem Falle können die Kommunikationsmodule aller Sensoren des Sensorsystems ihre jeweiligen Messdaten (separat) an die Entität in dem Netzwerk übertragen, insbesondere drahtlos. In diesem Falle können die Kommunikationsmodule aller Sensoren des Sensorsystems auch ausgebildet sein, sich autonom bei der Entität bekannt zu machen und/oder anzumelden, um eine Kommunikationssitzung einzuleiten.

Gemäß einer Ausführungsform der vorliegenden Erfindung ist das Sensorsystem ausgebildet, autark (z.B. ohne (kabelgebundene) Hilfe oder Unterstützung von außen, insbesondere ohne Kabelverbindung nach außen) zu arbeiten, indem es die zum Betrieb erforderliche Energie drahtlos, insbesondere durch induktive Übertragung (z.B. von einer naheliegenden Komponente) oder eine enthaltene Batterie/Akkumulator, erhält, und/oder über umgewandelte Abwärme erhält. Insbesondere braucht das Sensorsystem somit nicht mittels eines elektrischen Energieversorgungskabels mit einer Energieversorgung verbunden sein. Insbesondere kann jeder einzelne Sensor des Sensorsystems ausgebildet sein, autark zu arbeiten. Damit kann eine Komplexität der Vorrichtung vermindert werden, und insbesondere kann ein Installationsaufwand des Sensorsystems vermindert sein.

Gemäß einer Ausführungsform der vorliegenden Erfindung ist die Entität ausgebildet, einen Fertigungsprozess und/oder Transport und/oder Montage der Vorrichtung zu überwachen und/oder den Betrieb und/oder das Produkt zu optimieren und/oder Qualitätssicherung durchzuführen.

Das Sensorsystem zusammen mit dem Kommunikationssystem ist somit in vielfältiger Weise in verschiedenen Lebensabschnitten der Vorrichtung zur Überwachung einsetzbar.

Erfindungsgemäß ist die Vorrichtung eine Schaltanlage (Switchgear) im Mittel- bzw. Hochspannungsbereich.

Es sollte verstanden werden, dass Merkmale, welche individuell oder in irgendeiner Kombination im Zusammenhang mit einer Vorrichtung für Hoch- bzw. Mittelspannungs-Technik beschrieben, erläutert oder bereitgestellt sind, ebenso bzw. in entsprechender Abwandlung, individuell oder in irgendeiner Kombination für ein Verfahren für Hoch- bzw. Mittelspannungs-Technik angewendet werden können, und umgekehrt, gemäß Ausführungsformen der vorliegenden Erfindung.

Gemäß einer Ausführungsform der vorliegenden Erfindung ist bereitgestellt ein Verfahren für Hoch- bzw. Mittelspannungstechnik, aufweisend: Bereitstellen einer Vorrichtung mit einem Anschluss, der zur Verbindung mit einem Hoch- bzw. Mittelspannungsleiters ausgebildet ist; Bestimmen mehrerer verschiedener die Vorrichtung betreffender und/oder den Leiter und/oder die Umgebung betreffender physikalischer und/oder chemischer Messwerte; Übertragen, insbesondere drahtlos, der Messwerte an eine Entität in einem Netzwerk.

Gemäß einer Ausführungsform der vorliegenden Erfindung wird das Verfahren während einer Herstellung und/oder eines Transports und/oder einer Montage und/oder eines Betriebes und/oder einer Wartung der Vorrichtung ausgeführt.

Ausführungsformen der vorliegenden Erfindung werden nun mit Bezug auf die beiliegenden Zeichnungen erläutert. Die Erfindung ist nicht auf die illustrierten oder beschriebenen Ausführungsformen beschränkt.
Fig. 1 illustriert schematisch eine Vorrichtung für Hoch- bzw. Mittelspannungs-Technik gemäß einer Ausführungsform der vorliegenden Erfindung (auch als Sensorsystem bezeichnet)
Fig. 2 illustriert schematisch ein System (mit Netzwerk, Datenbank, Server) für Hoch- bzw. Mittelspannungs-Technik, welches eine Vorrichtung für Hoch- bzw. Mittelspannungs-Technik gemäß einer Ausführungsform der vorliegenden Erfindung umfasst; und
Fig. 3 illustriert schematisch ein System für Hoch- bzw. Mittelspannungs-Technik, welches eine Vorrichtung für Hoch- bzw. Mittelspannungs-Technik gemäß einer anderen Ausführungsform der vorliegenden Erfindung umfasst.

Ähnliche oder gleiche Strukturen oder Merkmale sind mit Bezugszeichen bezeichnet, die sich nur in der ersten Ziffer unterscheiden. Merkmale von verschiedenen Ausführungsformen können kombiniert werden.

Gemäß einer Ausführungsform der vorliegenden Erfindung umfasst eine Vorrichtung multi-funktionale Sensorik. Die multi-funktionale Sensorik (im Folgenden auch als Sensorsystem bezeichnet) sammelt kontinuierlich sämtliche relevanten Informationen, verarbeitet diese und kann sie autark in einer Datenbank (Cloud) (z.B. einer Entität, insbesondere Computer-Server) abspeichern. Da unter anderem GPS-Daten, Beschleunigungswerte und Temperaturverläufe gespeichert werden, kann der gesamte Herstellprozess der Vorrichtung auf Abweichungen überprüft werden. Zum Beispiel können im Fertigungsprozess Vibrationen von Fertigungsmaschinen mittels Beschleunigungs-Zeitverlauf erfasst werden. Ferner können Abläufe im Transportprozess erfasst werden, wobei Transportbelastungen durch autarke Systeme gemeldet werden können. Dabei können Überbeanspruchungen zeitnah erfasst werden und Maßnahmen können sofort eingeleitet werden, um den Überbeanspruchungen entgegen zu wirken.

Ferner können während der Montage bzw. der Inbetriebnahme Informationen mittels des Sensorsystems gesammelt werden. Allgemein können sich Sensoren des Sensorsystems selbständig im lokalen Netz anmelden bzw. bekanntmachen. Ferner können Sensoren des Sensorsystems, welche einzelnen Geräten zugeordnet sind, miteinander kommunizieren und relevante Informationen austauschen. Ferner kann eine Überwachung während eines Betriebs bzw. einer Wartung mittels des Sensorsystems und des Kommunikationssystems erfolgen, wobei basierend auf dem Betriebszustand der einzelnen Komponenten die Betriebsführung optimiert werden kann.

Gemäß Ausführungsformen der vorliegenden Erfindung kann eine kontinuierliche Überwachung des Produktlebenszyklus der Komponenten der Vorrichtung für Mittel- bzw. Hochspannungs-Technik durchgeführt werden. Die produktrelevanten Daten können durch eine autarke Sensorik in einer übergeordneten Datenbank (Cloud) gespeichert werden und können durch diverse Auswertungsapplikationen weiterverarbeitet werden. Dabei können Fertigungsprozesse überwacht werden, Transport und Montageüberwachung durchgeführt werden, Betriebsoptimierung durchgeführt werden, Produktoptimierung durchgeführt werden und es kann eine Qualitätssicherung durchgeführt werden.

Die Sensoren des Sensorsystems können in der Lage sein, neben betriebsbedingten Größen (z.B. Temperatur, Spannung, Strom, Gasdichte) auch für den Lebenszyklus relevante Daten zu detektieren (z.B. Beschleunigung, Vibration, Feuchtigkeit, GPS-Daten). Die Sensorik kann kontinuierlich und autark arbeiten und kann in der Lage sein, relevante Daten zur weiteren Verwendung in eine Datenbank zu übertragen, wofür das Kommunikationssystem herangezogen werden kann. Die Sensorik kann sich (z.B. über das verteilt oder zentral ausgelegte Kommunikationssystem) selbständig auf der Baustelle am lokalen Netzwerk anmelden und während der Montage/Inbetriebnahme die relevanten Daten austauschen, um die Qualitätssicherung zu dokumentieren.

Der gesamte Lebenszyklus des Produktes kann kontinuierlich überwacht werden. Dadurch können Produktionsverbesserungen erreicht, Fehlleistungskosten reduziert und die Betriebsführung optimiert werden.

Gemäß anderen Ausführungsformen der vorliegenden Erfindung wird das Sensorsystem zur Überwachung eines Betriebes der Vorrichtung für Mittel- bzw. Hochspannungs-Technik herangezogen. Dabei kann die autark funktionierende Sensorik kontinuierlich sämtliche relevanten Messwerte sammeln, diese verarbeiten (z.B. digitalisieren) und sie autark und drahtlos übertragen bzw. weiterverarbeiten (z.B. in abgeleitete Werte umwandeln, für interne Verarbeitungsalgorithmen verwenden ...). Der Datenfluss kann auch bidirektional erfolgen und somit ist eine Änderung der Sensorparameter der Sensoren des Sensorsystems ermöglicht. Zum Beispiel kann eine Umschaltung von Schutzfunktion auf eine Messfunktion bei Strommessung erfolgen, eine Genauigkeitsklassen-Anpassung kann erfolgen, eine Datenabtastrate kann gesetzt werden, etc.

Ein Sensor kann einer Komponente der Vorrichtung zugeordnet sein und kann sich (z.B. über das Kommunikationssystem bzw. ein dem Sensor zugeordneten Modul desselben) autonom an einer Anlagen-Datenbank anmelden (plug+play). Notwendige Informationen können direkt in der Datenbank abgelegt werden. Die Daten können im Sensor soweit vorverarbeitet werden (insbesondere mittels eines Vorverarbeitungssystems), dass die Algorithmen in der Datenbank höherwertige Funktionen (z.B. Schutz und Überwachung) ausführen können. Auf zusätzliche Hardware kann dabei verzichtet werden, indem "protection in the cloud" möglich wird. Einzige Funktion (z.B. Backup-Schutz, Vergleichswerterfassung, ...) werden im Sensor autark ausgeführt bzw. auch durch Kommunikation (via cloud) direkt mit einem oder mehreren Komponenten-Sensoren. Die Meldung bzw. der Steuerbefehl kann direkt an die betreffende Komponente erfolgen.

Durch Ausführungsform der vorliegenden Erfindung können verschiedene Vorteile erreicht werden. Zum Beispiel kann eine Verkabelung vereinfacht werden und oder die Verlegung von Kabeln kann ganz entfallen. Es kann eine Einsparung von Geräten und Reduktion der erforderlichen Steuer- und Schutzschränke erreicht werden, womit sich ein Platzbedarf reduzieren kann. Weiter kann sich ein Engineering-Aufwand reduzieren.

Die Sensorik kann kontinuierlich und autark arbeiten und in der Lage sein, relevante Daten zur weiteren Verwendung in eine Datenbank zu übertragen oder mit anderen Sensoren auszutauschen. Dabei kann eine Datenübertragung mittels Wireless plug+play erfolgen. Der Sensor kann an bestehende Komponenten adaptiert werden und neue Komponenten können die Sensorik ab Werk integriert haben. Die Datenerfassung kann dezentral in alternativen Ausführungsformen ohne durchgehende Transparenz durchgeführt werden.

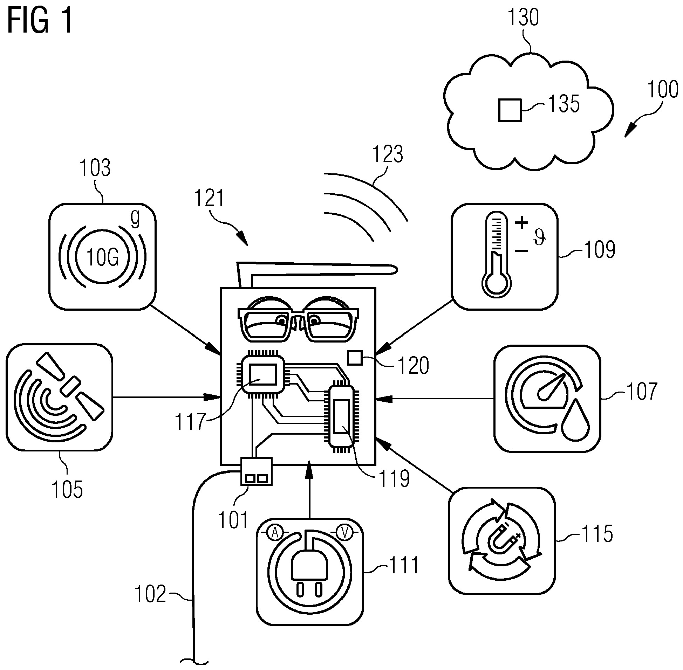

Fig. 1 illustriert schematisch eine Vorrichtung 100 für Hoch- bzw. Mittelspannungs-Technik gemäß einer Ausführungsform der vorliegenden Erfindung. Die in Fig. 1 illustrierte Vorrichtung 100 umfasst mindestens einen Anschluss 101, der zur Verbindung mit einem Hoch- bzw. Mittelspannungsleiters 102 ausgebildet ist, um somit einen Abzweig zu implementieren. Die Vorrichtung 100 umfasst ferner ein Sensorsystem bestehend aus einer Mehrzahl von Sensoren 103, 105, 107, 109, 111, 115 das ausgebildet ist, mehrere verschiedene die Vorrichtung 100 betreffende physikalische und/oder chemische Messwerte zu bestimmen und/oder physikalische und/oder chemische Messwerte zu bestimmen, die ein an den Anschluss 101 angeschlossenen elektrischen Leiter, z.B. Kabel oder gasisolierter Leiter oder Freileitungsleiter, betreffen, und/oder die Umgebung betreffende physikalische und/oder chemische Messwerte zu bestimmen. Insbesondere ist der Sensor 103 zum Bestimmen von Beschleunigungen ausgelegt, der Sensor 105 ist zum Bestimmen einer Position (via GPS) ausgelegt, der Sensor 107 ist zum Bestimmen einer Feuchte ausgelegt und der Sensor 109 ist zum Bestimmen der Temperatur ausgelegt. Der Sensor 111 kann zum Bestimmen von Strom und Spannung und der Sensor 115 kann zum Bestimmen von magnetischen Flüssen ausgelegt sein, welche an einem Kabel anliegen, welches an dem Anschluss 101 angeschlossen ist. Die Vorrichtung kann verschiedene Komponenten 117, 119 umfassen, welche zum Auswerten/Erfassen/Steuern von Messwerten verwendet werden und die einen normalen Betrieb der Vorrichtung, welche z.B. als eine Schaltanlage ausgebildet sein kann, ermöglichen. Die Sensoren kann jeweils einer oder mehreren Komponenten 117, 119 zugeordnet sein.

Die Vorrichtung 100 verfügt ferner über ein drahtloses Kommunikationssystem 121, welches ausgebildet ist, die Messwerte von den Sensoren 103, 105, 107, 109, 111, 115 zu erhalten und insbesondere drahtlos an eine Entität 135 in einem Netzwerk 130 zu übertragen, insbesondere nach einer Aufbereitung durch ein Vorverarbeitungssystem 120. Die Übertragung der Messwerte kann somit über Funkwellen 123 an die Entität 135 erfolgen.

Somit können die Daten erfasst werden und drahtlos an ein übergeordnetes System geschickt werden. Dabei kann sich das Kommunikationssystem 121 selbst autark in einer Cloud (z.B. Netzwerk 130) anmelden (z.B. WLAN plug+play). Ferner kann das Sensorsystem und/oder das Kommunikationssystem 121 eine autarke Versorgung, insbesondere Energieversorgung, haben. Ferner können das Sensorsystem und/oder das Kommunikationssystem die Messwerte insbesondere die Messdaten soweit vorverarbeiten, dass die Daten in der Cloud (insbesondere von der Entität, z.B. Computer-Server, 135) genutzt werden können. Eine einfache Grundkonfiguration (Komponentenadressierung, ...) kann über MLFB realisiert sein (z.B. mit DIP-Schalter). Ein bidirektionaler Datenfluss kann zwischen dem Kommunikationssystem 121 und der Entität 135 und/oder den Sensoren erfolgen, um z.B. eine Umschaltung von Schutz- auf Messfunktion bei Strommessung zu ermöglichen, eine Genauigkeitsklassenanpassung zu ermöglichen, eine Datenabtastrate zu setzen, etc. Einzelne Funktionen (z.B. Backup-Schutz, Vergleichswerteerfassung, ...) kann das Sensorsystem autark ausführen bzw. auch durch Kommunikation direkt mit einem oder mehreren Komponenten-Sensoren durchführen. Die Vorrichtung kann ferner eine Meldung und Steuerung seiner zugehörigen Komponenten übernehmen.

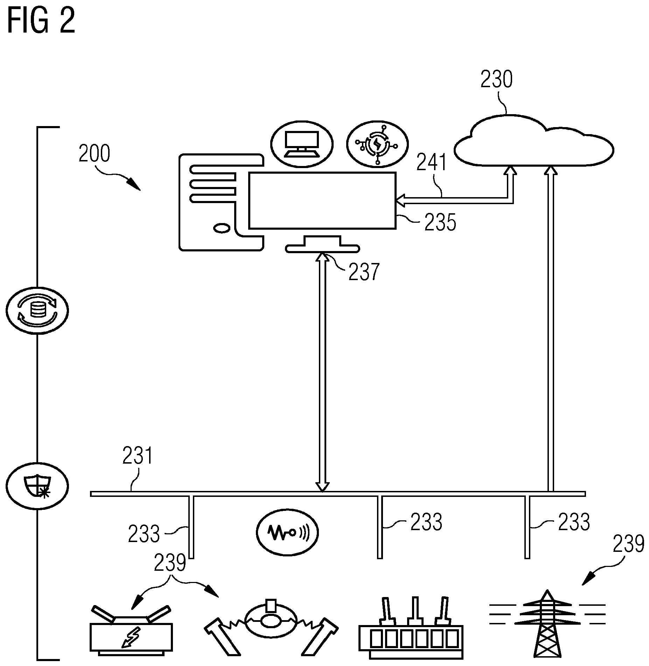

Fig. 2 illustriert schematisch eine Vorrichtung 200 gemäß einer Ausführungsform der vorliegenden Erfindung, welche mit einem Netzwerk 230 (z.B. verbunden mit einer Cloud) verbunden ist. Die Vorrichtung 200 umfasst ein Kommunikationssystem 231 mit einer Anzahl von Zweigen 233, welche ermöglichen, mit Ausstattungskomponenten 239 zu verbinden. Ferner umfassen die Ausstattungskomponenten 239 Sensoren, welche gemäß Ausführungsform der vorliegenden Erfindung überwacht werden können mittels eines nicht im Detail dargestellten Sensorsystems. Die Messwerte des Sensorsystems werden als Messsignale 237 an eine Steuer- und Überwachungseinheit 235 (entspricht in Fig. 1 der Entität 135 in einem Netzwerk), die mit einem nicht im Detail dargestellten Kommunikationssystem ausgestattet bzw. verbunden ist, übermittelt. Die Steuer- und Überwachungseinheit 235 ist über einen Kommunikationslink 241 (drahtlos oder drahtgebunden) mit dem Netzwerk 230 (z.B. das Internet oder ein Datensee) verbunden. Das Kommunikationssystem ist ausgebildet, die Messwerte von dem Sensorsystem zu empfangen und an die Entität 235 in dem Netzwerk 230 zu übertragen.

Die Sensoren des Sensorsystems können Energie aus ihrem Umfeld als Versorgungsenergie erhalten werden (z.B. Induktion in den HV-Geräten, umgewandelte Abwärme, etc.). Die Sensoren des Sensorsystems können sich einem umgebenden Netzwerk (z.B. drahtloses Netzwerk) selbständig bekannt machen und können z.B. signalisieren, welche Komponente überwacht wird und welche Art von Daten geschickt wird. In einer übergeordneten Cloud können die von den Sensoren erhaltenen Messdaten oder Messwerte verarbeitet werden, indem Algorithmen ablaufen, die der Sensor selber nicht mehr handhaben kann oder die aus anderen Stationen erfasst werden. Zeitkritische Funktionen können/sollen direkt von dem erfassenden Sensor an den ausführenden gesendet werden.

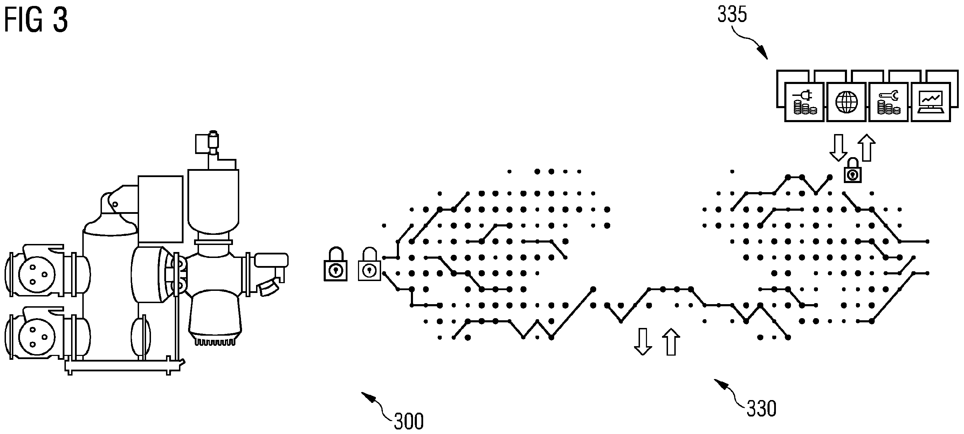

Fig. 3 illustriert schematisch eine weitere Vorrichtung 300 gemäß einer Ausführungsform der vorliegenden Erfindung, welche mit einem Netzwerk 330 verbunden ist. Die Vorrichtung 300 kann z.B. als eine Schaltanlage ausgebildet sein und umfasst ein Sensorsystem sowie ein Kommunikationssystem, welches in kommunikativ über Verschlüsselungsfunktionen mit dem Netzwerk 330 verbunden werden kann. Innerhalb des Netzwerks 330 ist eine Entität 335 angeordnet, welche z.B. eine Datenbank enthalten kann, an welche die Messwerte, die in der Vorrichtung 300 erhalten sind, gesendet werden.

## Patentansprüche

1. Schaltanlage (100, 200, 300) für Hoch- bzw. Mittelspannungstechnik, aufweisend:
zumindest einen Anschluss (101), der zur Verbindung mit einem Hoch- bzw. Mittelspannungsleiter (102), insbesondere Kabel und/oder gasisolierter Leiter und/oder Freileitungsleiter, ausgebildet ist, wobei die Schaltanlage mindestens eine Sammelschiene enthält, die den Knoten eines Hoch-, Mittel- oder Niederspannungsnetzes bildet und über Schaltgeräte mit anderen Netzknoten verbindbar ist;
ein Sensorsystem (103, 105, 107, 109, 111, 115), das ausgebildet ist, mehrere verschiedene die Schaltanlage betreffende und/oder den Leiter und/oder die Umgebung betreffende physikalische und/oder chemische Messwerte zu bestimmen;
ein, insbesondere drahtlos arbeitendes, Kommunikationssystem (121), das ausgebildet ist, die Messwerte von dem Sensorsystem zu empfangen und an eine Entität (135) in einem Netzwerk zu übertragen, **dadurch gekennzeichnet, dass**
das Kommunikationssystem (121) ausgebildet ist, bidirektionale Kommunikation zu erlauben, um
Sensorkonfigurationsdaten zu erhalten und an das Sensorsystem (103, 105, 107, 109, 111, 115) zu übermitteln, welche das Sensorsystem hinsichtlich Schutzfunktion und/oder Messfunktion und/oder Empfindlichkeit und/oder Abtastrate konfigurieren und
Steuerdaten, die Steuersignale an Komponenten der Schaltanlage umfassen, zu erhalten und an die Komponenten der Schaltanlage zu übertragen, um einen Betrieb der Schaltanlage zu steuern, um so eine Verbindung zu dem Hoch- oder Mittelspannungsleiter zu schließen bzw. zu unterbrechen.

2. Schaltanlage gemäß einem der vorangehenden Ansprüche, ferner aufweisend:
ein Vorverarbeitungssystem (120), um die Messwerte zur Übertragung vorzubereiten, insbesondere zu digitalisieren und/oder mit Identifikationsdaten und/oder Zeitstempel zu versehen und/oder in mindestens ein Übertragungsdatenpaket zu konvertieren.

3. Schaltanlage gemäß einem der vorangehenden Ansprüche, wobei die Messwerte
Standortdaten und/oder
Beschleunigung und/oder
Temperatur und/oder
Drehmoment und/oder
Druckbeanspruchung und/oder
Verweildauer
der Schaltanlage betreffen
und/oder
Strom und/oder
Spannung und/oder
Temperatur und/oder
Druck und/oder
Beschleunigung und/oder
Vibration und/oder
Feuchte
des Leiters betreffen, das mit der Schaltanlage verbunden ist.

4. Schaltanlage gemäß einem der vorangehenden Ansprüche, wobei das Kommunikationssystem (121) ausgebildet ist, sich autonom bei der Entität (135), insbesondere einer Datenbank, und/oder im Netzwerk (130) bekannt zu machen und/oder anzumelden.

5. Schaltanlage gemäß einem der vorangehenden Ansprüche, wobei das Sensorsystem (121) ausgebildet ist, autark zu arbeiten, indem es die zum Betrieb erforderliche Energie drahtlos, insbesondere durch induktive Übertragung, erhält, und/oder über umgewandelte Abwärme.

6. Schaltanlage gemäß einem der vorangehenden Ansprüche, wobei die Entität (135) ausgebildet ist, einen Fertigungsprozess und/oder Transport und/oder Montage zu überwachen und/oder Betrieb und/oder das Produkt zu optimieren und/oder Qualitätssicherung durchzuführen.

7. Verfahren für Hoch- bzw. Mittelspannungstechnik, aufweisend:
Bereitstellen einer Schaltanlage (100, 200, 300) mit einem Anschluss (101) nach Anspruch 1 bis 6, die zur Verbindung mit einem Hoch- bzw. Mittelspannungsleiter (102) ausgebildet ist;
Bestimmen mehrerer verschiedener die Schaltanlage betreffender und/oder den Leiter und/oder die Umgebung betreffender physikalischer und/oder chemischer Messwerte;
Übertragen, insbesondere drahtlos, der Messwerte an eine Entität (135) in einem Netzwerk (130), wobei
die Kommunikation bidirektional erfolgt, um Sensorkonfigurationsdaten zu erhalten und an das Sensorsystem (103, 105, 107, 109, 111, 115) zu übermitteln, welche das Sensorsystem hinsichtlich Schutzfunktion und/oder Messfunktion und/oder Empfindlichkeit und/oder Abtastrate konfigurieren und Steuerdaten zu erhalten, die Steuersignale an Komponenten der Schaltanlage umfassen, und an die Komponenten der Schaltanlage zu übertragen, um einen Betrieb der Schaltanlage zu steuern, um so eine Verbindung zu dem Hoch- oder Mittelspannungsleiter zu schließen bzw. zu unterbrechen.

8. Verfahren gemäß dem vorangehenden Anspruch, wobei das Verfahren während:
einer Herstellung und/oder
eines Transports und/oder
einer Montage und/oder
eines Betriebes und/oder
einer Wartung der Schaltanlage ausgeführt wird.

## Claims

1. Switchgear apparatus (100, 200, 300) for high-voltage or medium-voltage technology, comprising:
at least one connection (101) designed for being connected to a high-voltage or medium-voltage conductor (102), in particular cable and/or gas-insulated conductor and/or overhead line conductor, wherein the switchgear apparatus contains at least one busbar which forms the node of a high-voltage, medium-voltage or low-voltage grid and is connectable to other grid nodes via switching devices;
a sensor system (103, 105, 107, 109, 111, 115) designed to determine a plurality of different physical and/or chemical measurement values relating to the switchgear apparatus and/or relating to the conductor and/or the surroundings;
a communication system (121), operating in particular wirelessly, which is designed to receive the measurement values from the sensor system and to transmit them to an entity (135) in a network, **characterized in that**
the communication system (121) is designed to allow bidirectional communication so as
to obtain sensor configuration data and to communicate them to the sensor system (103, 105, 107, 109, 111, 115), said data configuring the sensor system with regard to protection function and/or measurement function and/or sensitivity and/or sampling rate, and
to obtain control data comprising control signals to components of the switchgear apparatus and to transmit them to the components of the switchgear apparatus in order to control operation of the switchgear apparatus, in order thus to establish or to interrupt a connection to the high-voltage or medium-voltage conductor.

2. Switchgear apparatus according to one of the preceding claims, furthermore comprising:
a preprocessing system (120) in order to prepare the measurement values for transmission, in particular to digitize them and/or to provide them with identification data and/or a time stamp and/or to convert them into at least one transmission data packet.

3. Switchgear apparatus according to either of the preceding claims, wherein the measurement values relate to
location data and/or
acceleration and/or
temperature and/or
torque and/or
compressive stress and/or
residence duration
of the switchgear apparatus
and/or relate to
current and/or
voltage and/or
temperature and/or
pressure and/or
acceleration and/or
vibration and/or
moisture
of the conductor connected to the switchgear apparatus.

4. Switchgear apparatus according to any of the preceding claims, wherein the communication system (121) is designed to autonomously make itself known and/or log on to the entity (135), in particular a database, and/or in the network (130).

5. Switchgear apparatus according to any of the preceding claims, wherein the sensor system (121) is designed to operate autonomously by obtaining the energy required for operation wirelessly, in particular by inductive transmission, and/or by way of converted waste heat.

6. Switchgear apparatus according to any of the preceding claims, wherein the entity (135) is designed to monitor a manufacturing process and/or transport and/or assembly and/or to optimize operation and/or the product and/or to carry out quality assurance.

7. Method for high-voltage or medium-voltage technology, comprising:
providing a switchgear apparatus (100, 200, 300) having a connection (101) according to claims 1 to 6, which is designed for being connected to a high-voltage or medium-voltage conductor (102) ;
determining a plurality of different physical and/or chemical measurement values relating to the switchgear apparatus and/or relating to the conductor and/or the surroundings;
transmitting, in particular wirelessly, the measurement values to an entity (135) in a network (130), wherein
the communication takes place bidirectionally in order to obtain sensor configuration data and to communicate them to the sensor system (103, 105, 107, 109, 111, 115), said data configuring the sensor system with regard to protection function and/or measurement function and/or sensitivity and/or sampling rate, and to obtain control data comprising control signals to components of the switchgear apparatus and to transmit them to the components of the switchgear apparatus in order to control operation of the switchgear apparatus, in order thus to establish or to interrupt a connection to the high-voltage or medium-voltage conductor.

8. Method according to the preceding claim, wherein the method is carried out during:
production and/or
transport and/or
assembly and/or
operation and/or
maintenance
of the switchgear apparatus.

## Revendications

1. Installation (100, 200, 300) de distribution de la technique de la haute tension ou de la moyenne tension, comportant :
au moins une borne (101), qui est constituée pour la connexion à un conducteur (102) de la haute tension ou de la moyenne tension, en particulier un câble et/ou un conducteur à isolation par du gaz et/ou un conducteur aérien, dans laquelle l'installation de distribution comporte au moins une barre collectrice, qui forme les noeuds d'un réseau de haute tension, de moyenne tension ou de basse tension et qui peut être connectée à d'autres noeuds du réseau par des appareils de coupure ;
un système (103, 105, 107, 109, 111, 115) capteur, qui est constitué pour déterminer plusieurs valeurs de mesure physiques et/ou chimiques différentes concernant l'installation de distribution et/ou le conducteur et/ou l'environnement ;
un système (121) de communication, fonctionnant en particulier sans fil, qui est constitué pour recevoir les valeurs de mesure du système capteur et les transmettre à une entité (135) d'un réseau, **caractérisé en ce que**
le système (121) de communication est constitué pour permettre une communication bidirectionnelle,
afin d'obtenir et de transmettre au système (103, 105, 107, 109, 111, 115) capteur des données de configuration de capteur, qui configurent le système capteur en ce qui concerne une fonction de protection et/ou une fonction de mesure et/ou une sensibilité et/ou un taux d'échantillonnage et
d'obtenir des données de commande, qui comprennent des signaux de commande de composants de l'installation de distribution, et de les transmettre aux composants de l'installation de distribution, afin de commander un fonctionnement de l'installation de distribution, pour ainsi fermer ou interrompre une connexion au conducteur de haute tension ou de moyenne tension.

2. Installation de distribution suivant l'une des revendications précédentes, comportant en outre :
un système (120) de prétraitement pour prétraiter des valeurs de mesure pour la transmission, en particulier pour les numériser et/ou les munir de données d'identification et/ou d'estampilles temporelles et/ou les transformer en au moins un paquet de données de transmission.

3. Installation de distribution suivant l'une des revendications précédentes, dans laquelle les valeurs de mesure concernent
des données de localisation et/ou
une accélération et/ou
une température et/ou
un couple et/ou
une sollicitation en pression et/ou
un temps de séjour
de l'installation de distribution
et/ou
un courant et/ou
une tension et/ou
une température et/ou
une pression et/ou
une accélération et/ou
une vibration et/ou
une humidité
du conducteur, qui est connecté à l'installation de distribution.

4. Installation de distribution suivant l'une des revendications précédentes, dans laquelle le système (121) de communication est constitué pour se faire connaître et/ou s'annoncer de manière autonome auprès de l'entité (135), en particulier auprès d'une base de données et/ou dans le réseau (130) .

5. Installation de distribution suivant l'une des revendications précédentes, **caractérisée en ce que** le système (121) capteur est constitué pour travailler de manière autarcique, **en ce qu'**il obtient l'énergie nécessaire au fonctionnement sans fil, en particulier par transport inductif et/ou par transformation de la chaleur perdue.

6. Installation de distribution suivant l'une des revendications précédentes, dans laquelle l'entité (135) est constituée pour contrôler une opération de fabrication et/ou un transport et/ou un montage et/ou pour optimiser un fonctionnement et/ou le produit et/ou pour effectuer un contrôle de qualité.

7. Procédé de la technique de la haute tension ou de la moyenne tension, comportant :
on se procure une installation (100, 200, 300) de distribution ayant une borne (101) suivant la revendication 1 à 6, qui est constituée pour la connexion à un conducteur (102) de la haute tension ou de la moyenne tension ;
on détermine plusieurs valeurs de mesure physiques et/ou chimiques différentes concernant l'installation de distribution et/ou concernant le conducteur et/ou l'environnement ;
on transmet, en particulier sans fil, des valeurs de mesure à une entité (135) d'un réseau (130), dans lequel la communication a lieu bidirectionnellement, afin d'obtenir et de transmettre au système (103, 105, 107, 109, 111, 115) capteur des données de configuration de capteur, lesquelles configurent le système capteur en ce qui concerne une fonction de protection et/ou une fonction de mesure et/ou une sensibilité et/ou un taux d'échantillonnage et d'obtenir des données de commande, qui comprennent des signaux de commande de composants de l'installation de distribution et de les transmettre aux composants de l'installation de distribution, afin de commander un fonctionnement de l'installation de distribution, pour ainsi fermer ou interrompre une connexion au conducteur de la haute tension ou de la moyenne tension.

8. Procédé suivant la revendication précédente, dans lequel on effectue le procédé pendant :
une fabrication et/ou
un transport et/ou
un montage et/ou
un fonctionnement et/ou
un entretien
de l'installation de distribution.
